# EUROPÄISCHE PATENTSCHRIFT

(11) **EP 0 973 204 B1**
(45) Veröffentlichungstag und Bekanntmachung des Hinweises auf die Patenterteilung: **01.03.2006**
(21) Anmeldenummer: 99112270.6
(22) Anmeldetag: 25.06.1999
(51) Int. Cl.: H01L 29/78, H01L 21/336, H01L 21/266, H01L 21/8234

(54) **Verfahren zur Herstellung einer MOS-Transistoranordnung**
Method of manufacturing a MOS-Transistor device
Procédé pour la fabrication d'un dispositif de transistor MOS

(30) Priorität: 26.06.1998 DE 19828522
(43) Veröffentlichungstag der Anmeldung: 19.01.2000
(73) Patentinhaber: ELMOS Semiconductor AG, 44227 Dortmund (DE)
(72) Erfinder: Gehrmann, Andreas, 44267 Dortmund (DE); Bornefeld, Ralf, 58579 Schalksmühle (DE)
(74) Vertreter: Hilleringmann, Jochen

(56) Entgegenhaltungen:
- WO-A-97/13277
- US-B- 5 075 242
- ALIAHMAD M ET AL: "A SHORT LOOP SLIC IN A SUBMICRON BICMOS TECHNOLOGY" IEEE INTERNATIONAL SYMPOSIUM ON POWER SEMICONDUCTOR DEVICES AND ICS,US,NEW YORK, NY: IEEE, Bd. CONF. 9, 26. Mai 1997 (1997-05-26), Seiten 329-332, XP000800213 ISBN: 0-7803-3994-0
- RAMEZANI M ET AL: "A MONOLIGHIC IGBT GATE DRIVER IMPLEMENTED IN A CONVENTIONAL 0.8MUM BICMOS PROCESS" KYOTO, JUNE 3 - 6, 1998,NEW YORK, NY: IEEE,US, 3. Juni 1998 (1998-06-03), Seiten 109-112, XP000801044 ISBN: 0-7803-4752-8
- PATENT ABSTRACTS OF JAPAN vol. 1995, no. 04, 31. Mai 1995 (1995-05-31) & JP 07 030107 A (SONY CORP), 31. Januar 1995 (1995-01-31)

## Beschreibung

Die Erfindung betrifft ein Verfahren zur Herstellung einer MOS-Transistoranordnung mit einem Hochvolt-(HV-)MOS-Transistor mit niedrigem Einschaltwiderstand und einem Niedervolt-Logik-MOS-Transistor.

Aus ALIAHMAD M ET AL: 'A SHORT LOOP SLIC IN A SUBMICRON BICMOS TECHNOLOGY' IEEE INTERNATIONAL SYMPOSIUM ON POWER SEMICONDUCTOR DEVICES AND ICS,US,NEW YORK, NY: IEEE, Bd. CONF. 9, 26. Mai 1997 (1997-05-26), Seiten 329-332, XP000800213 ISBN: 0-7803-3994-0 und RAMEZANI M ET AL: 'A MONOLITHIC IGBT GATE DRIVER IMPLEMENTED IN A CONVENTIONAL 0.8MUM BICMOS PROCESS' KYOTO, JUNE 3-6, 1998,NEW YORK; NY: IEEE,US, 3. Juni 1998 (1998-06-03), Seiten 109-112, XP000801044 ISBN: 0-7803-4752-8 sind NMOS-Transistoren bekannt, bei denen unterhalb eines Drainextension-Gebietes eine vergrabene Schicht (buried layer) angeordnet ist. Die Dotierstoffkonzentration der vergrabenen Schicht ist höher als die Dotierstoffkonzentration innerhalb des Drainextension-Gebietes. Damit ergibt sich, ausgehend von der Substratoberfläche, in Tiefenerstreckung des Substrats ein retrogrades Dotierstoffkonzentrationsprofil.

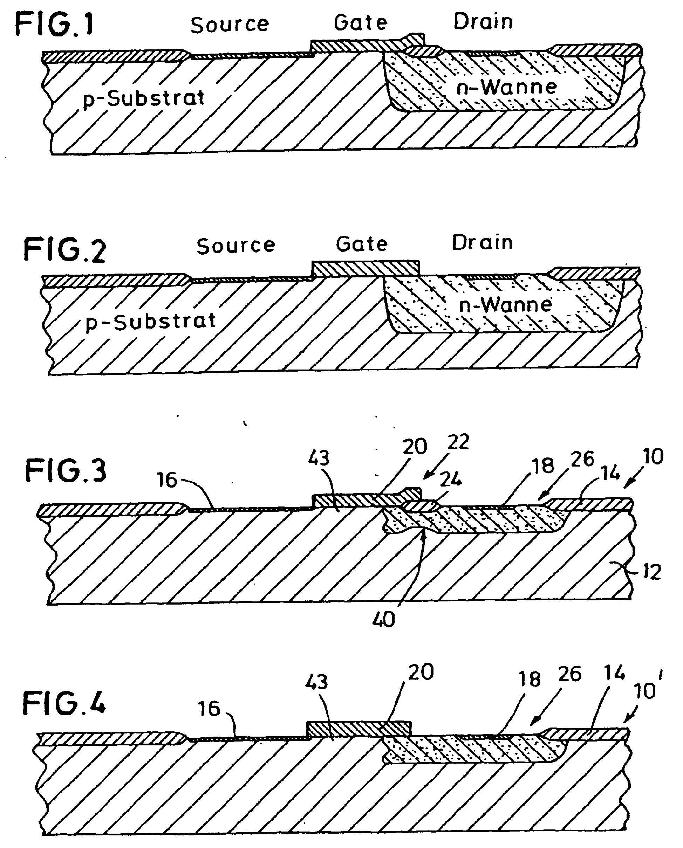

Die derzeit verwendeten HV-NMOS-Transistoren mit einer Sperrspannung von bis zu ca. 150 Volt sind aufgrund der spannungsoptimierten Konstruktion für Spannungsbereiche um 20 Volt flächenmäßig unrentabel. Die dort verwendete diffundierte n-Wanne als Drainextension (Fig. 1), auch in Verbindung mit einer Feldplatte (Fig. 2), stellt den klassischen Ansatz zur Erhöhung der Spannungsfestigkeit dar. Da diese n-Wanne in ihrer Dotierung so ausgelegt wurde, dass sie zur Aufnahme des Komplementärtransistors (PMOS) geeignet ist, liegt ihre Dotierung auf einem eher niedrigen Niveau. Diese wirkt bei Verwendung als Drainextension limitierend für die Performance des Transistors in Bezug auf die Stromergiebigkeit.

Der vorhandene NMOS-Logiktransistor dagegen ist auf gerade diese Stromergiebigkeit optimiert, verfügt aber nicht über die notwendige Spannungsfestigkeit.

In CMOS-Prozessen werden neben Logiktransistoren für den 5 Volt Spannungsbereich auch HV-Transistoren für Spannungen größer 30 Volt realisiert. Diese sind auf die im Automotive-Bereich üblichen Spitzenspannungen 30/40/50 Volt, aber auch zur Unterstützung gegen Störimpulse bis zu ca. 150 Volt, optimiert. Auch der Spannungsbereich 10 Volt bis 30 Volt wird derzeit mit diesen HV-Transistoren aufgrund nicht vorhandener Spezialtransistoren abgedeckt. Mit speziell optimierten Transistoren für diesen Spannungsbereich soll eine höhere Performance und damit eine Flächenerspamis erzielt werden.

Wichtige Randbedingung für den neuen MOS-Transistor stellt der verfügbare CMOS-Prozess dar, der nicht verändert und auch nicht erweitert werden soll. Die Herstellung des neuen MOS-Transistors darf sich nicht auf schon existierende Bauelemente und deren Parameter auswirken.

In herkömmlichen CMOS-Prozessen bis ca. 1,0 µm sind keine Möglichkeiten zur Realisierung der neuen Bauelemente vorhanden, ohne den Prozess zu modifizieren und damit Parameterveränderungen an existierenden Bauelementen zu provozieren. Dies liegt in der auf die Hochvolteigenschaften optimierte Wannenkonstruktion begründet, die die Logiktransistoren in den Hochvoltwannen erzeugt und damit keine Möglichkeit zur separaten Optimierung von Logik- und Hochvoltteil zulässt.

In typischen Submicron-Technologien, bei denen es sich zumeist um Mischtechnologien handelt, in der Logik- und Hochvoltbauelemente getrennt optimiert werden können, stehen aber neben den bisher verwendeten Wannendotierungsgebieten neue Wannen zur Verfügung, die zur Aufnahme von ebenfalls neuen komplementären Logiktransistoren mit reduziertem Gateoxid dienen (sog. Niedervolt-Transistoren). Diese Niedervolt-Wannen sind geeignet, das gewünschte Bauelement zu realisieren.

Der Erfindung liegt die Aufgabe zugrunde, ein Verfahren zur Herstellung einer MOS-Transistoranordnung mit einem Hochvolt-MOS-Transistor mit hoher Spannungsfestigkeit und niedrigem Einschaltwiderstand und einem Logik-MOS-Transistor zu schaffen, wobei der Hochvolt-MOS-Transistor unter Verwendung von für den Logik-MOS-Transistor erforderlichen Prozessschritten herstellbar ist.

Zur Lösung dieser Aufgabe wird mit der Erfindung eine MOS-Transistoranordnung mit einem Hochvolt-MOS-Transistor mit hoher Spannungsfestigkeit und niedrigem Einschaltwiderstand und einem Logik-MOS-Transistor gemäß Anspruch 1 vorgeschlagen.

Bei dem Hochvolt-MOS-Transistor der erfindungsgemäß hergestellten Anordnung wird das zur Erhöhung der Spannungsfestigkeit erforderliche Drainextension-Gebiet durch einen Ionenimplantationsschritt erzeugt, wobei die Implantation in ihrem der Oberseite des Substrats zugewandten oberseitennahen Bereich eine niedrigere Dotierstoff-Konzentration aufweist als in ihrem Bereich unterhalb dieses oberseitennahen Bereichs. Mit anderen Worten weist das Drainextension-Gebiet ein sogenanntes retrogrades Profil auf. Dies hat den Vorteil, dass als Drainextension eine implantierte retrograde Wanne eingesetzt werden kann, wie für den Niedervoit-Transistor (Logiktransistor) der erfindungsgemäßen Anordnung in typischen Submicron-Technologien verwendet wird. Damit kann zur Herstellung des erfindungsgemäßen Hochvolt-MOS-Transistors auf Prozessschritte zurückgegriffen werden, wie sie gegenwärtig bereits für die Erzeugung integrierter Niedervolt-MOS-Logiktransistoren eingesetzt werden. Die Prozessführung bleibt damit unverändert und wird insbesondere nicht um zusätzliche Prozessschritte erweitert. Insbesondere bleibt auch der thermische Haushalt unverändert.

In vorteilhafter Weiterbildung der Erfindung ist ferner vorgesehen, wenn das Drainextension-Gebiet mittels eines zwei- bzw. dreischrittigen Implantationsprozesses realisiert wird, wobei als zweite und/oder dritte Implantation die von Niedervolt-Transistoren her bekannten Ionenimplantationen zur Schwellwerteinstellung und zur Verhinderung eines Punch-Through-Effekts eingesetzt werden.

Ein weiterer Vorteil des HV-MOS-Transistors der erfindungsgemäß hergestellten Anordnung ist darin zu sehen, dass eine erhöhte Performance bei verringertem Flächenbedarf erzielt wird. Die Stromergiebigkeit des erfindungsgemäßen HV-Transistors ist verbessert, wohingegen die Spannungsfestigkeit aufgrund der weniger weichen Dotierungsverläufe in den Eckenbereichen des retrograden Implantationsprofils in gewisser Weise limitiert ist. Letztendlich ist die Spannungsfestigkeit aber für die im Automotive-Bereich geltenden Anforderungen ausreichend, so dass bei dem erfindungsgemäßen Transistor vorzugsweise die Flächenersparnis zu Buche schlägt.

Die wesentliche Neuerung der erfindungsgemäß hergestellten MOS-TransistorAnordnung ist also in der Verwendung eines retrograden Wannenprofils zur Erzeugung der Drainextension des HV-MOS-Transistors zu sehen, so dass die für die Niedervolt-Logiktransistoren optimierten retrograden Wannen als Drainextension für Hochvoltbauelemente eingesetzt werden können, wodurch sich sowohl eine unveränderte als auch einfache Prozessführung ohne Zusatzschritte ergibt.

Entgegen dem klassischen Verfahren mit Erzeugung einer diffundierten Drainextension zur Verbesserung der Spannungsfestigkeit wird erfindungsgemäß ein implantiertes, retrogrades Dotierungsprofil eingesetzt. Dieses besteht je nach Prozessführung aus 1 bis 3 Implantationen:
- der Wannenimplantation (WI) selbst, hochenergetisch implantiert in hoher Tiefe > 1 µm,
- eventuell der oberflächennahen VT-Implantation (VTI) zur Einstellung der Einschaltschwelle (Schwellwerteinstellung) und/oder
- eventuell einer Anti-Punch-Through-Implantation (APTI) auf etwa der Tiefe der Drain-/Source-Gebiete (< 0,5 µm), durch die die Ausdehnung der Raumladungszone am Drain in Richtung Source begrenzt wird.

Die Implantationen WI und APTI werden durch das Feldoxid maskiert und gelangen damit nur in die aktiven Gebiete. Die WI durchdringt das Feldoxid und formt in unmittelbarer Tiefe unter diesem eine hochdotierte Schicht. Kombiniert man beides in einem Bauelement mit Feldplatte, wie es gemäß einer vorteilhaften Ausgestaltung der Erfindung vorgesehen ist, ergeben sich folgende Vor-/Nachteile gegenüber den klassischen Verfahren:
- Im aktiven Bereich unter dem Gate verhindert insbesondere die APTI ein erhöhtes Feld an der Feldoxidkante, da hierdurch der Dotierungsgradient der Drainwanne abgeschwächt wird. Dadurch wird die Spannungsfestigkeit verbessert.
- Im Bereich unter der Feldplatte bewirkt die WI eine niederohmige Anbindung des Drains an den Kanal. Dies wirkt sich positiv auf die Stromergiebigkeit des Transistors aus und stellt die entscheidende Verbesserung gegenüber dem klassischen Verfahren dar.
- Die weniger weichen Dotierungsverläufe in den Ecken des retrograden Implantationsprofils limitieren die maximal erreichbare Spannungsfestigkeit. Sie liegt typisch unter den mit klassischer Methode erreichbaren Werten.

Weiterhin ist mit dem beschriebenen Implantationsprofil auch ein Bauelement denkbar, das auf eine Feldplatte verzichtet. Dieses bietet unter Nutzung der gleichen Vorteile bei reduzierter Spannungsfestigkeit einen geringeren Flächenbedarf.

Eine weitere Erhöhung der Spannungsfestigkeit ist mit einer sogenannten "modulierten Wannenimplantation" (PCT-Anmeldung PCT/EP96/04246, Veröffentlichungsnummer WO-A-97/13277) machbar. Diese Methode läßt sich ebenfalls auf die oben beschriebenen Bauelemente anwenden, weshalb der Inhalt der PCT-Anmeldung auch zum Gegenstand der vorliegenden Anmeldung gemacht wird.

An dieser Stelle soll noch gesagt werden, daß die beschriebenen neuen Bauelemente nicht nur als Typ n-Kanal realisiert werden können. Die Machbarkeit des Typs p-Kanal ist durch die Nutzung der p-Niedervolt-Wanne als Drainextension innerhalb der vorhandenen HV-n-Wanne als Body ebenfalls möglich.

Nachfolgend werden anhand der Figuren Ausführungsbeispiele der Erfindung näher ertäutert. Im einzelnen zeigen:
- Fig. 1: einen Schnitt durch einen HV-NMOS-Transistor nach dem Stand der Technik mit diffundiertem Drainextension-Gebiet und Feldplatte unterhalb der drainseitigen Kante der Gate-Elektrode,
- Fig. 2: einen Schnitt durch einen HV-NMOS-Transistor nach dem Stand der Technik mit diffundiertem Drainextension-Gebiet und ohne Feldplatte,
- Fig. 3: einen Schnitt durch einen MOS-Transistor der erfindungsgemäß hergestellten Anordnung mit implantiertem Drainextension-Gebiet und Feldplatte,
- Fig. 4: einen Schnitt durch einen MOS-Transistor gemäß einem weiteren Ausführungsbeispiel der erfindungsgemäß hergestellten Anordnung mit implantiertem Drainextension-Gebiet und ohne Feldplatte,
- Fig. 5: eine Darstellung der Dotierstoff-Konzentration in Abhängigkeit der Tiefe der Implantation des Drainextension-Gebiets, und zwar unterhalb der Gate-Elektrode und unterhalb der Feldplatte, und
- Fig. 6: einen Schnitt durch ein Substrat, in dem neben zwei HV-MOS-Transistoren auch zwei Logik-Niedervolt-Transistoren der erfindungsgemäß hergestellten Anordnung dargestellt sind.

Fig. 3 zeigt einen Längsschnitt durch ein erstes Ausführungsbeispiel eines MOS-Transistors 10 der erfindungsgemäß hergestellten Anordnung, bei dem es sich um einen NMOS handelt. Der MOS-Transistor 10 ist in einem p-dotierten Substrat 12 ausgebildet, dessen Aktivgebiet durch eine Öffnung in einer Feldoxidschicht 14 definiert ist. Der NMOS-Transistor 10 weist entartet n-dotierte Source- und Drain-Gebiete 16,18 auf, zwischen denen eine Gate-Elektrode 20 angeordnet ist. Die Gate-Elektrode 20 weist einen dem Drain-Gebiet 18 zugewandten drainseitigen Endbereich 22 auf, unterhalb dessen eine Feldplatte 24 aus Siliziumoxid angeordnet ist.

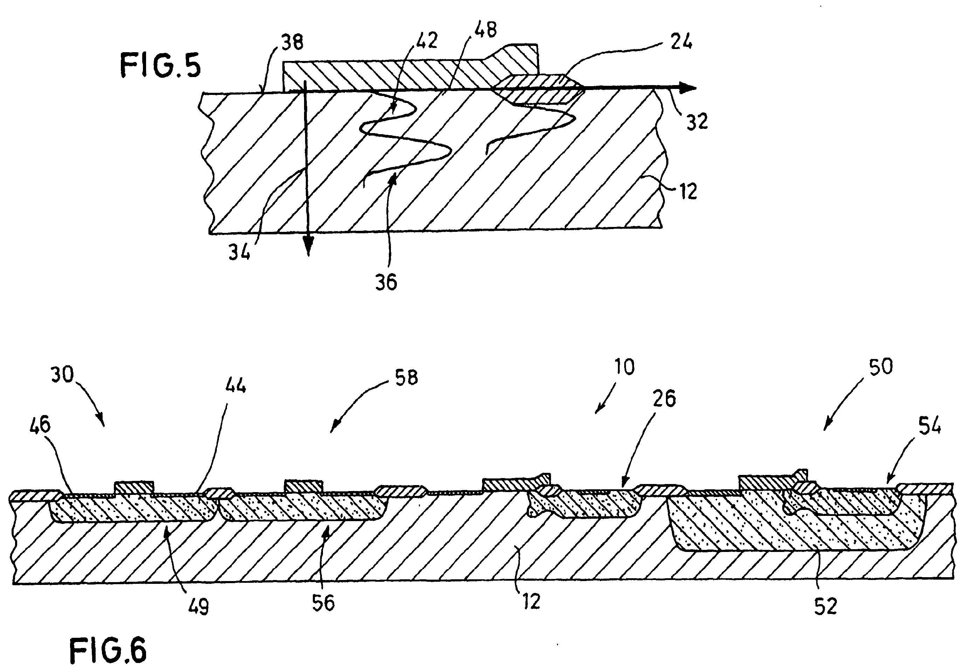

Das Drain-Gebiet 18 befindet sich in einem Drainextension-Gebiet 26, das durch Ionenimplantation erzeugt ist. Bei dieser Ionenimplantation handelt es sich um diejenige Implantation, die auch zur Ausbildung einer Wanne innerhalb des Substrats 12 verwendet wird, innerhalb derer dann ein NMOS-Niedervolt-Logiktransistor ausgebildet. Ein derartiger Logiktransistor ist in Fig. 6 bei 30 dargestellt.

Das Drainextension-Gebiet 26 ist n-dotiert und weist eine mit zunehmender Tiefe ansteigende Dotierstoff-Konzentration auf. Insoweit entsteht ein retrogrades Wannenprofil, das in Fig. 5 wiedergegeben ist. In dieser Figur ist längs der Achse 32 die Dotierstoff-Konzentration über der längs der Achse 34 aufgetragenen Tiefe wiedergegeben. Das Dotierstoff-Konzentrationsprofil 36, das von der Substratoberfläche 38 beabstandet im oberflächennahen Bereich des Substrats 12 ausgebildet ist, ist auf den Implantationsprozeß zur Einbringung eines Wannengebietes im Substrat zurückzuführen, wobei ein derartiges Wannengebiet auch bei der Ausbildung des Logiktransistors 30 benötigt wird. Die bei Einbringung dieser Implantation bereits ausgebildete Feldplatte 24 führt dazu, daß unterhalb der Feldplatte 24 die Implantation nicht so weit in das Substrat 12 eindringt, wie außerhalb der Feldplatte 24. Dies ist in Fig. 3 durch die Ausbuchtung 40 am Grund des Drainextension-Gebiets 26 dargestellt. Zusätzlich zu diesem ersten Implantationsschritt kommt bei dem Transistor 10 gemäß Fign. 3 und 5 noch ein zweiter Implantationsschritt hinzu, und zwar der Implantationsschritt zur Einbringung einer Anti-Punch-Through-Implantation. Das sich dadurch ergebende Dotierstoff-Konzentrationsprofil ist in Fig. 5 bei 42 gezeigt. Dieser Implantationsschritt ist weniger energiereich als der zuerst beschriebene und durchgeführte Implantationsschritt, weshalb sich das Dotierstoff-Konzentrationsprofil 42 im Bereich zwischen dem Profil 36 und der Substratoberfläche 28 ausbildet, wobei die Energie derart gering ist, daß die Ionenimplantation die Feldplatte 24 nicht durchdringt und sich somit lediglich unterhalb der Gate-Elektrode 20 ausbildet. Diese Anti-Punch-Through-Implantation wird beim Logiktransistor 30 benötigt, um eine Ausdehnung der Raumladungszone des Drain-Gebiets 44 des Logiktransistors 30 in Richtung zum Source-Gebiet 46 zu begrenzen.

Ein weiterer Ionenimplantationsschritt kann durchgeführt werden, und zwar derjenige zur Einstellung der Einschaltschwelle (Schwellwerteinstellung) des Logiktransistors 30. Auch dieser Implantationsschritt wird in das Drainextension-Gebiet 26 eingebracht, wobei sich die hierdurch hervorgerufene Dotierstoff-Konzentration an der Substratoberfläche 38 auswirkt. In Fig. 5 ist das hierdurch hervorgerufene Dotierstoff-Konzentrationsprofil nicht dargestellt.

Insgesamt ist damit das Drainextension-Gebiet 26 des HV-Transistors 10 durch bis zu drei Implantationsschritten erzeugt, wobei sich eine mit zunehmender Tiefe vergrößernde Dotierstoff-Konzentration innerhalb des Kanal-Gebiets 48 einstellt. Durch die Wannen-Implantation direkt unter der Feldplatte 24 erfolgt die niederohmige Anbindung des Drainextension-Gebiets 26 an das KanalGebiet 48.

Fig. 4 zeigt ein alternatives Ausführungsbeispiel eines NMOS-Transistors 10' der erfindungsgemäß hergestellten Anordnung, der bis auf die Feldplatte 24 identisch mit dem NMOS-Transistor 10 gemäß Fig. 3 ist. Bei dem Ausführungsbeispiel gemäß Fig. 4 fehlt diese Feldplatte 24; dies wirkt sich auf die Dotierstoff-Konzentrationsverteilung innerhalb des Drainextension-Gebiets 26 aus, was letztendlich dazu führt, daß die Spannungsfestigkeit des Transistors 10' gegenüber der Spannungsfestigkeit des Transistors 10 leicht reduziert ist. Ferner ergibt sich infolge der Feldplatte 24 auch innerhalb des Gebiets 26 ein retrogrades Dotierungsprofil, wodurch der Stromfluß zwischen dem Kanalgebiet 48 unterhalb der Gate-Elektrode 20 und dem Drain-Gebiet 18 nicht ausschließlich an der Oberfläche sondern ganz überwiegend im Volumen des Drainextension-Gebiets 26, also in dessen Tiefe erfolgt. Das hat den Vorteil, daß die Stromführung nicht durch Oberflächeneffekte beeinträchtigt und damit zuverlässiger und reproduzierbarer ist.

Fig. 6 schließlich zeigt die Ausbildung von erfindungsgemäß hergestellten MOS-Transistoranordnungen mit Logiktransistoren und HV-Transistoren in ein und demselben Substrat 12. Zu erkennen ist, daß das Drainextension-Gebiet 26 des HV-NMOS-Transistors 10 auch als Aktivgebiet 49 für den Logik-NMOS-Transistor 30 eingesetzt wird. Wird die Erfindung bei einem HV-PMOS-Transistor 50 genutzt, der innerhalb einer HV-n-Wanne 52 des Substrats 12 ausgebildet ist, so entspricht das Drainextension-Gebiet 54 dieses HV-PMOS-Transistors 50 der Wanne 56 eines in das p-Substrat 12 integrierten Logik-PMOS-Transistors 58.

## Patentansprüche

1. Verfahren zur Herstellung einer MOS-Transistoranordnung, die versehen ist mit
- einem Hochvolt-MOS-Transistor (10;50), der aufweist
- ein Substrat (12), das mit Ladungsträgern eines ersten Leitungstyps dotiert ist,
- in dem Substrat (12) ausgebildete Source- und Drain-Gebiete (16;18), die mit Ladungsträgern eines zum ersten Leitungstyp entgegengesetzten zweiten Leitungstyp dotiert sind,
- eine Gate-Elektrode (20), die im Bereich zwischen dem Drain- und dem Source-Gebiet (18;16) auf dem Substrat (12) angeordnet ist und einen drainseitigen Endbereich (22) aufweist, und
- ein Drainextension-Gebiet (26;54), das mit Ladungsträgern des zweiten Ladungstyps dotiert ist, mit dem Drain-Gebiet (18) verbunden ist und sich lateral bis unterhalb des drainseitigen Endes (22) der Gateelektrode (20) erstreckt,
- wobei das Drainextension-Gebiet (26;54) in seinem der Oberseite des Substrats (12) zugewandten oberseitennahen Bereich eine niedrigere Dotierstoff-Konzentration aufweist als in seinem Bereich unterhalb des oberseitennahen Bereichs, und mit
- einem Logik-MOS-Transistor (30; 58), der in einem in das Substrat (12) eingebrachten Aktivgebiet (49;56) ausgebildet ist,
- wobei das Drainextension-Gebiet (26;54) durch einen mindestens einen ersten Implantationsschritt umfassenden Ionenimplantationsprozess erzeugt wird, und
- wobei das Aktivgebiet (49;56) durch den ersten Ionenimplantationsschritt des das Drainextension-Gebiet (26;54) des Hochvolt-MOS-Transistors (10;50) erzeugenden Ionenimplantationsprozess gebildet wird.

2. Verfahren nach Anspruch 1, **dadurch gekennzeichnet, dass** unterhalb des drainseitigen Endes (22) der Gate-Elektrode (20) des Hochvolt-MOS-Transistors (10;50) eine Feldoxid-Platte (24) angeordnet ist.

3. Verfahren nach Anspruch 1 oder 2, **dadurch gekennzeichnet, dass** das Drainextension-Gebiet (26;54) des Hochvolt-MOS-Transistors (10;50) und das Aktivgebiet (49;56) für den Logik-MOS-Transistor (30;58) durch einen den ersten Implantationsschritt sowie einen zweiten Implantationsschritt umfassenden Ionenimplantationsprozess gebildet werden, wobei durch den zweiten Implantationsschritt
- in das Drainextension-Gebiet (26;54) Ionen mit einer Energie, die niedriger als die Energie der Ionen des ersten Implantationsschrittes ist, implantiert werden und
- in das Aktivgebiet (49;56) eine Ionenimplantation zur Schwellwerteinstellung des Logik-MOS-Transistors (30;58) eingebracht wird.

4. Verfahren nach einem der Ansprüche 1 bis 3, **dadurch gekennzeichnet, dass** das Drainextension-Gebiet (26; 54) des Hochvolt-MOS-Transistors (10;50) und das Aktivgebiet (49;56) für den Logik-MOS-Transistor (30;58) durch eine den ersten und den zweiten Implantationsschritt sowie einen dritten Implantationsschritt umfassenden Ionenimplantationsprozess gebildet werden, wobei durch den dritten Implantationsschritt
- in das Drainextension-Gebiet (26;54) Ionen mit einer Energie, die zwischen den Energien der Ionen des ersten und des zweiten Implantationsschritts liegt, implantiert werden und
- in das Aktivgebiet (49;56) eine Anti-Punch-Through-Implantation eingebracht wird.

5. Verfahren nach Anspruch 2 und 3 oder 2 und 4, **dadurch gekennzeichnet, dass** die Feldoxid-Platte (24) der Ausmaskierung jeder Implantation mit einer Energie, die kleiner ist als die Energie der mit dem ersten Implantationsschritt eingebrachten Implantation, dient, so dass sich unterhalb der Feldoxid-Platte (24) lediglich die mit dem ersten Implantationsschritt eingebrachten Ionen befinden.

## Claims

1. Method for manufacturing a MOS transistor assembly, comprising
- a high-volt MOS transistor (10;50) having
- a substrate (12) doped with charge carriers of a first conductivity type,
- source and drain regions (16;18) configured in the substrate (12), doped with charge carriers of a second conductivity type opposed to the first conductivity type,
- a gate electrode (20) arranged on the substrate (12) in the region between the drain and the source regions (18;16) and comprising a drain-side end (22) region, and
- a drain extension region (26;54) doped with charge carriers of the second conductivity type, connected with the drain region (18) and extending up to below the drain-side end (22) of the gate electrode (20),
- wherein said drain extension region (26;54) comprises, in its area near the top side and facing the top side of the substrate (12), a lower doping material concentration than in its area below the area located near the top side, and having
- a logic MOS transistor (30;58) configured in an active region (49;56) which is introduced into the substrate (12),
- wherein the drain extension region (26;54) is produced by an ion implantation process comprising at least one first implantation step, and
- wherein the active region (49;54) is generated by the first ion implantation step of the ion implantation process producing the drain extension region (26;54) of the high-volt MOS transistor (10;50).

2. The method according to claim 1, **characterized in that** below the drain-side end (22) of the gate electrode (20) of the high-volt MOS transistor (10;50) a field oxide plate (24) is arranged.

3. The method according to claim 1 or 2, **characterized in that** the drain extension region (26;54) of the high-volt MOS transistor (10;50) and the active region (49;56) for the logic MOS transistor (30;58) are produced by an ion implantation process comprising the first implantation step and a second implantation step, wherein in the second implantation step
- ions with an energy lower than the energy of the ions of the first implantation step are implanted into the drain extension region (26;54), and
- an ion implantation for threshold value adjustment of the logic MOS transistor (30;58) is introduced into the active region (49;56).

4. The method according to any one of claims 1 to 3, **characterized in that** the drain extension region (26;54) of the high-volt MOS transistor (10;50) and the active region (49;56) for the logic MOS transistor (30;58) are produced by an ion implantation process comprising the first and the second implantation step and a third implantation step, wherein in the third implantation step
- ions with an energy lying between the energies of the ions of the first and the second implantation steps are implanted into the drain extension region (26; 54), and
- an anti-punch-through implantation is introduced into the active region (49; 56).

5. The method according to claim 2 and 3 or 2 and 4, **characterized in that** the field oxide plate (24) is configured for masking each implantation at an energy which is lower than the energy of the implantation introduced in the first implantation step, such that below the field oxide plate (24) only the ions introduced in the first implantation step are located.

## Revendications

1. Dispositif de fabrication d'un dispositif de transistors MOS muni
- d'un transistor MOS haute tension (10 ; 50) qui présente
- un substrat (12) dopé avec des porteurs de charge d'un premier type de conduction,
- des zones de source et de drain (16 ; 18) formées dans le substrat (12) qui sont dopées avec des porteurs de charge d'un deuxième type de conduction opposé au premier type de conduction,
- une électrode de grille (20) qui est disposée dans la région entre les zones de drain et de source (18 ; 16) sur le substrat et présente une région terminale (22) côté drain, et
- une zone d'extension de drain (26 ; 54) qui est dopée avec des porteurs de charge du deuxième type de conduction, reliée à la zone de drain (18) et s'étend latéralement jusqu'en dessous de l'extrémité côté drain (22) de l'électrode de grille (20),
- dans lequel la zone d'extension de drain (26 ; 54), dans sa région proche de la face supérieure tournée vers la face supérieure du substrat (12), présente une concentration de substance de dopage inférieure à celle de sa région sous la région proche de la face supérieure, et
- d'un transistor MOS logique (30 ; 58) qui est formé dans une zone active (49 ; 56) aménagée dans le substrat (12),
- dans lequel la zone d'extension de drain (26 ; 54) est générée par un processus d'implantation d'ions comprenant au moins une première étape d'implantation, et
- dans lequel la zone active (49 ; 56) est formée par la première étape d'implantation d'ions du processus d'implantation d'ions générateur de la zone d'extension de drain (26 ; 54) du transistor MOS haute tension (10 ; 50).

2. Procédé selon la revendication 1, **caractérisé en ce qu'**une plaque d'oxyde de champ (24) est disposée en dessous de l'extrémité côté drain (22) de l'électrode de grille (20) du transistor MOS haute tension (10 ; 50).

3. Procédé selon la revendication 1 ou 2, **caractérisé en ce que** la zone d'extension de drain (26 ; 54) du transistor MOS haute tension (10 ; 50) et la zone active (49 ; 56) pour le transistor MOS logique (30 ; 58) sont formées par un processus d'implantation d'ions comprenant une première étape d'implantation et une deuxième étape d'implantation, dans lequel par la deuxième étape d'implantation
- des ions sont implantés dans la zone d'extension de drain (26 ; 54) avec une énergie qui est inférieure à l'énergie des ions de la première étape d'implantation, et
- une implantation d'ions est effectuée dans la zone active (49 ; 56) pour régler la valeur seuil du transistor MOS logique (30 ; 58).

4. Procédé selon l'une quelconque des revendications 1 à 3, **caractérisé en ce que** la zone d'extension de drain (26 ; 54) du transistor MOS haute tension (10 ; 50) et la zone active (49 ; 56) pour le transistor MOS logique (30 ; 58) sont formées dans un processus d'implantation d'ions comprenant la première et la deuxième étapes d'implantation ainsi qu'une troisième étape d'implantation, dans lequel par la troisième étape d'implantation
- des ions étant implantés dans la zone d'extension de drain (26 ; 54) avec une énergie qui se situe entre les énergies des ions de la première et de la deuxième étape d'implantation, et
- une implantation anti-tension de perçage est réalisée dans la zone active (49; 56).

5. Procédé selon les revendications 2 et 3 ou 2 et 4, **caractérisé en ce que** la plaque d'oxyde de champ (24) sert à masquer chaque implantation avec une énergie qui est inférieure à l'énergie de l'implantation introduite avec la première étape d'implantation, de sorte que seuls les ions introduits avec la première étape d'implantation se trouvent en dessous de la magnétorésistance (24).
